# EUROPÄISCHE PATENTSCHRIFT

(11) **EP 1 318 547 B1**
(45) Veröffentlichungstag und Bekanntmachung des Hinweises auf die Patenterteilung: **17.04.2013**
(21) Anmeldenummer: 01811188.0
(22) Anmeldetag: 06.12.2001
(51) Int. Cl.: H01L 25/11, H01L 23/48

(54) **Leistungshalbleiter-Modul**
Power semiconductor module
Module semi-conducteur à haut prestation

(43) Veröffentlichungstag der Anmeldung: 11.06.2003
(73) Patentinhaber: ABB Research Ltd., 8050 Zürich (CH)
(72) Erfinder: Zwick, Fabian, 8134 Adliswil (CH); Bijlenga, Bo, 662 33 Amal (SE); Erne, Patrick, 8352 Elsau (CH); Linder, Stefan, 4800 Zofingen (CH)
(74) Vertreter: ABB Patent Attorneys

(56) Entgegenhaltungen:
- EP-A- 0 923 127
- EP-A2- 0 762 496
- WO-A-98/12748
- US-A- 3 183 407
- US-A- 4 047 197
- US-A- 4 853 762

## Beschreibung

### Technisches Gebiet

Die Erfindung bezieht sich auf das Gebiet der Leistungselektronik. Sie betrifft ein Leistungshalbleiter-Modul nach dem Oberbegriff des Patentanspruchs 1.

### Stand der Technik

Im Hochleistungsbereich werden Leistungshalbleiter-Module in der Druckkontakttechnik (Press Pack Module) gefertigt. Diese Press Pack Module werden als Hochleistungsschalter im Hochspannungsbereich bis 1'000 kV für Ströme bis zu mehreren kA eingesetzt. Da ein Insulated Gate Bipolar Transistor (IGBT), wie er heute in einem Press Pack Modul verwendet wird, lediglich eine Spannung von rund einigen kV sperren kann, werden für einen Hochspannungsschalter mehrere Press Pack Module in mindestens einem Stapel (Stack) in Serie geschaltet. Der Stack mit bis mehreren Dutzend Press Pack Modulen wird mit einer Kraft von rund 100 kN zusammengepresst.

Ein herkömmliches Press Pack Modul, wie es beispielsweise in EP 762'496 beschrieben ist, umfasst in der Regel mehrere, nebeneinander angeordnete Halbleiterchips, welche mit einer ersten Hauptelektrode auf einer Grundplatte aufgebracht sind. Zweite Hauptelektroden der Halbleiterchips werden von einer Mehrzahl von Kontaktstempeln kontaktiert. Die Grundplatte ist mit einem ersten Hauptanschluss und die Kontaktstempel sind mit einem zweiten Hauptanschluss verbunden. Die Hauptanschlüsse können scheibenförmig ausgebildet sein und mittels Flanschen zusammengehalten werden. Der Kontaktstempel umfasst beispielsweise Federelemente, welche auf die einzelnen Chips drücken.

Die einzelnen Halbleiterchips des Press Pack Moduls werden vielfach gruppiert und in vorfabrizierbaren Einheiten, sogenannte Submodule, zusammengefasst. Dabei sind die Halbleiterchips zueinander parallel geschaltet, beispielsweise ein IGBT- und ein Dioden-Chip gemeinsam in einem Submodul.

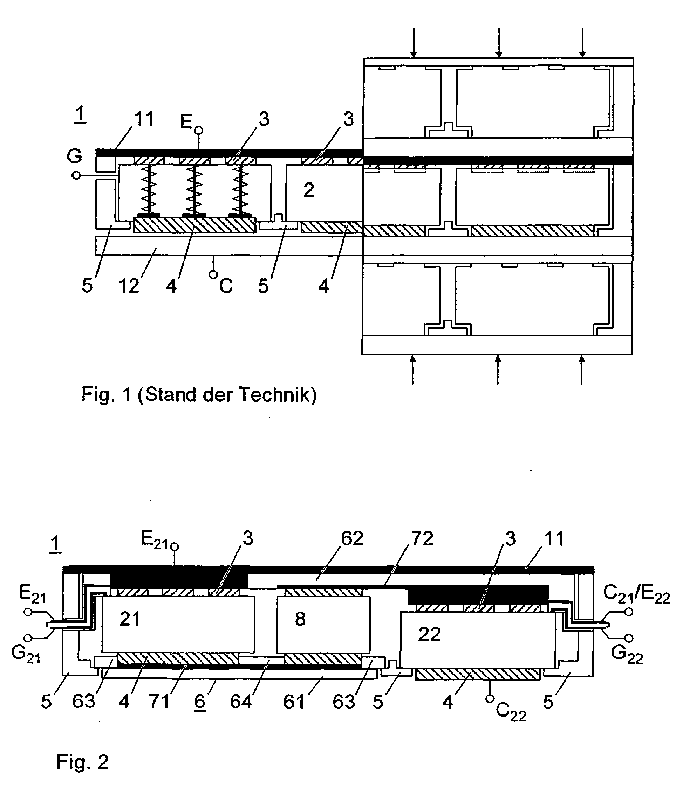

Ein solches Press Pack Modul ist in der anhängigen europäischen Patentanmeldung mit der Anmeldenummer 01810539.5 beschrieben, und schematisch in Fig. 1 dargestellt. Die Figur ist in zwei Hälften aufgeteil, wobei auf der linken Hälfte eine Hälfte des Moduls im vormontierten Zustand und auf der rechten Hälfte die andere Hälfte des Moduls im montiertem Zustand in einem Stack von drei Modulen dargestellt ist.

Das Modul mit den drei dargestellten Submodulen 2 wird dabei gegen eine elektrisch und thermisch gut leitende Grundplatte 12 gepresst, die beispielsweise eine von einer Kühlflüssigkeit durchflossene Kühlplatte sein kann.

Bereits im vormontierten Zustand sind die von oben in das Isoliergehäuse 5 eingebrachten Submodule 2 mit einer Federspannung beaufschlagt und werden gegen die fest mit dem Isoliergehäuse verbundene Deckelplatte 11 gepresst. Die Federspannung wird von Federelementen in den einzelnen Submodulen erzeugt und auf die ersten Hauptanschlüsse 3 übertragen. Die zweiten Hauptanschlüsse 4 ragen unten aus dem Isoliergehäuse 5 hervor um einen sicheren Kontakt zur Grundplatte 12 zu gewährleisten.

Im montierten Zustand sind die zweiten Hauptanschlüsse 4 der Submodule durch eine auf die Grund- und die Deckelplatte ausgeübte Anpresskraft ins Innere des Modulgehäuses gedrückt. Dabei werden die Federelemente komprimiert, wodurch ein erhöhte Kontaktkraft auf die Elektroden der Halbleiterchips im Innern der Submodule wirkt. Das Isoliergehäuse sorgt dabei dafür, dass die Federelemente nicht zu stark komprimiert werden, damit die Kontaktkraft nicht zu gross wird.

Ein Stack mit Press Pack Modulen erreicht eine Länge von mehreren Metern. Um den oben erwähnten Druck über eine solche Länge ausüben zu können, sind aufwendige Vorkehrungen notwendig. Es ist daher erstrebenswert, die maximale Sperrspannung pro Längeneinheit in einem Stack zu erhöhen, um für eine gegebene Spannung mit weniger Press Pack Modulen auszukommen.

Durch eine Erhöhung der Sperrspannung einzelner Press Pack Module könnten die Höhe des Stacks und die damit verbundenen Kosten reduziert werden. Leider ist die oben erwähnte maximale Sperrspannung der Leistungshalbleiterchips mit der heutigen Technologie kaum zu überbieten.

### Kurze Darstellung der Erfindung

Es ist daher die Aufgabe der vorliegenden Erfindung, ein Leistungshalbleiter-Modul der eingangs genannten Art zu schaffen, welches eine höhere Sperrspannung pro Bauhöhe aufweist.

Diese Aufgabe wird erfindungsgemäss mit einem Leistungshalbleiter-Modul mit den Merkmalen des Patentanspruchs 1 gelöst.

Das erfindungsgemässe Leistungshalbleiter-Modul umfasst zwischen zwei elektrischen Hauptanschlüssen, welche auf einander gegenüberliegenden, im wesentlichen parallelen Hauptoberflächen des Moduls angeordnet sind, mindestens zwei Submodule. Die Submodule weisen zwei elektrische Hauptanschlüsse auf, welche auf je einer von zwei einander gegenüberliegenden, im wesentlichen parallelen Hauptoberflächen der Submodule angeordnet sind. Die Submodule umfassen je mindestens einen Halbleiterchip, welcher zwei Hauptelektroden aufweist, welche mit den Hauptanschlüssen des Submoduls elektrisch leitend verbunden sind. Die Submodule sind nebeneinander angeordnet und mit einer der beiden Hauptoberflächen an die Deckelplatte angepresst. Mindestens zwei Submodule sind elektrisch in Serie geschaltet.

Durch die Serienschaltung von zwei oder mehreren nebeneinander angeordneten Submodulen kann im Vergleich zu herkömmlichen Press Pack Modulen die Sperrspannung verdoppelt oder vervielfacht werden.

Dadurch reduziert sich die Länge und die Kosten eines Stacks da für die gleichen Sperrspannungen weniger Komponenten, insbesondere weniger Kühlelemente, gebraucht werden,.

Die Bauhöhe des erfindungsgemässen Leistungshalbleiter-Moduls vergrössert sich gegenüber herkömmlichen Press Pack Modulen nur geringfügig. Die zusätzliche Vergrösserung führt jedoch zu einer verbesserten mechanischen Stabilität des Moduls, was insbesondere in langen Stacks besonders vorteilhaft zum tragen kommt.

Weiter ist es möglich, für gleichbleibende oder grössere Sperrspannungen im Vergleich zu herkömmlichen Press Pack Modulen günstigere Halbleiterchips mit geringerer Sperrspannung zu verwenden. Da solche Halbleiterchips mit der halben Sperrspannung zusammen weniger Verluste produzieren als ein einzelner Halbleiterchip mit der vollen Sperrspannung, können in herkömmlichen Stacks bei gleichbleibenden Abmessungen mit den erfindungsgemässen Leistungshalbleiter-Modulen auch die Verluste reduziert werden.

In einer ersten Ausführungsform des Leistungshalbleiter-Moduls ist der erste Hauptanschluss mindestens eines ersten Submoduls mit der Deckelplatte elektrisch leitend verbunden. Zwischen dem zweiten Hauptanschluss des mindestens einen ersten Submoduls und der der Deckelplatte gegenüberliegenden Hauptoberfläche des Moduls ist eine erste elektrisch isolierende Schicht und zwischen dem ersten Hauptanschluss mindestens eines zweiten Submoduls und der Deckelplatte ist eine zweite elektrisch isolierende Schicht angeordnet. Der zweite Hauptanschluss des mindestens einen zweiten Submoduls ist mit dem zweiten Hauptanschluss des Moduls elektrisch leitend verbunden. Der zweite Hauptanschluss des mindestens einen ersten Submoduls ist mit dem ersten Hauptanschluss des mindestens einen zweiten Submoduls über eine Verbindung elektrisch leitend verbunden ist.

Die Submodule sind elektrisch in Serie geschaltet, wodurch sich für das Leistungshalbleiter-Modul mit IGBT-Halbleitern eine doppelte Sperrspannung ergibt.

In einer zweiten Ausführungsform des Leistungshalbleiter-Moduls ist zwischen dem ersten Hauptanschluss mindestens eines ersten Submoduls und der der Deckelplatte gegenüberliegenden Hauptoberfläche des Moduls eine erste elektrisch isolierende Schicht angeordnet ist. Der erste Hauptanschluss des mindestens einen ersten Submoduls ist über eine erste Verbindung mit der Deckelplatte elektrisch leitend verbunden. Zwischen dem zweiten Hauptanschluss des mindestens einen ersten Submoduls und der Deckelplatte sowie zwischen dem ersten Hauptanschluss mindestens eines zweiten Submoduls und der Deckelplatte ist eine zweite elektrisch isolierende Schicht angeordnet. Der zweite Hauptanschluss des mindestens einen zweiten Submoduls ist mit dem zweiten Hauptanschluss des Moduls elektrisch leitend verbunden. Der zweite Hauptanschluss des mindestens einen ersten Submoduls ist mit dem ersten Hauptanschluss des mindestens einen zweiten Submoduls über zweite Verbindung elektrisch leitend verbunden.

Die Submodule sind bei gleicher Ausrichtung im Modul elektrisch antiseriel geschaltet. Dadurch ergibt sich mit IGBT-Halbleitern ein abschaltbares Vier-Quadranten-Leistungshalbleiter-Modul, welches beispielsweise als Wechselstrom-Schalter in Matrixstromrichter eingesetzt wird.

Weitere Ausführungsbeispiele und Vorteile ergeben sich aus den entsprechenden abhängigen Ansprüchen.

### Kurze Beschreibung der Zeichnungen

Nachfolgend wird die Erfindung anhand von Ausführungsbeispielen im Zusammenhang mit den Zeichnungen näher erläutert. Es zeigen:
- Fig. 1: ein Schnitt durch ein Leistungshalbleiter-Modul nach dem Stand der Technik, im vormontierten (linke Bildhälfte) und im montierten Zustand (rechte Bildhälfte),
- Fig. 2: eine Schnitt durch eine erste Ausführungsform eines erfindungsgemässen Leistungshalbleiter-Moduls mit zwei seriell geschalteten Submodulen, und
- Fig. 3: eine Schnitt durch das Leistungshalbleiter-Modul gemäss Fig. 2 mit zwei anti-seriell geschalteten Submodulen,
- Fig. 4: ein Schema des Leistungshalbleiter-Muduls gemäss Fig. 2,
- Fig. 5: ein Schema des Leistungshalbleiter-Muduls gemäss Fig. 3, und
- Fig. 6: ein Schnitt durch das Leistungshalbleiter-Modul gemäss Fig. 3 beim Montieren.

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Weg zur Ausführung der Erfindung

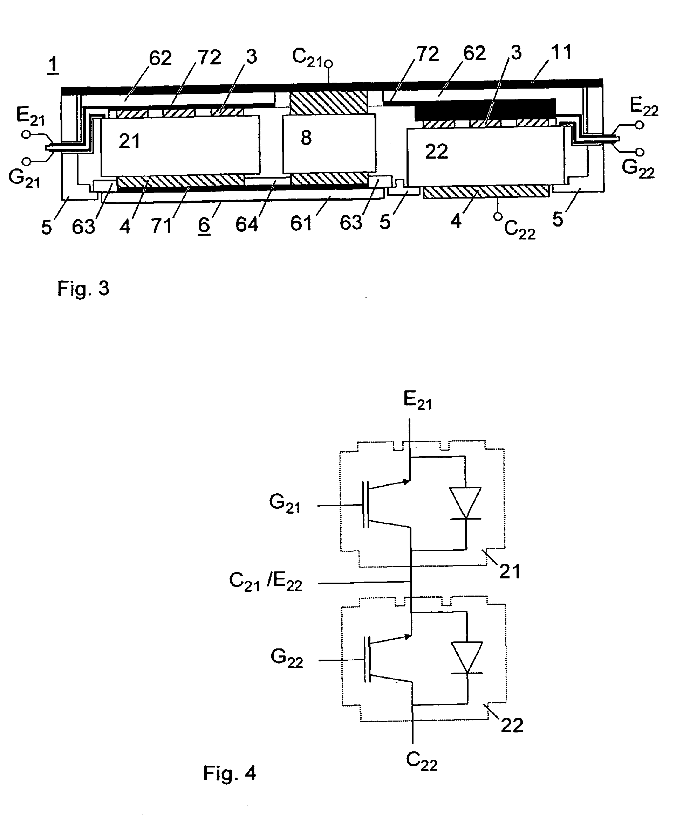

Die Fig. 2 und 3 zeigen zwei Ausführungsformen des erfindungsgemässen Leistungshalbleiter-Moduls. Das Modul umfasst eine elektrisch leitende Deckelplatte 11, ein mit der Deckelplatte schlüssig verbundenes, elektrisch isolierendes Gehäuse 5 und mehrere Submodule 21 und 22.

Die Deckelplatte 11 ist aus einem elektrisch und thermisch gut leitenden Metall, beispielsweise Kupfer oder Aluminium, gefertigt. Sie bildet den ersten elektrischen Hauptanschluss E₂₁ des Moduls, welcher beispielsweise in einem Stack mit dem Hauptanschluss eines darüberliegenden Moduls elektrisch verbunden ist.

Das Gehäuse 5 ist aus einem elektrisch isolierenden, mechanisch und thermisch belastbaren Material, beispielsweise Epoxy, gefertigt. Das Gehäuse umfasst seitliche Wandbereiche, welche den Hauptanteil der in einem Press Pack Stack auf das Modul ausgeübten Anpresskraft tragen, sowie einen Bodenbereich. Die Deckelplatte und der Bodenbereich des Gehäuses bilden zwei gegenüberliegende, im wesentlichen parallele Hauptoberflächen des Moduls. Im Bodenbereich sind Öffnungen 51 in das Gehäuse eingelassen, durch die ein zweiter elektrischer Hauptanschluss des Moduls C₂₂ aus dem Gehäuse geführt ist.

Im Innern des Moduls sind zwei an sich bekannte Leistungshalbleiter-Submodule 21 und 22 nebeneinander angeordnet. Die Submodule umfassen in der Regel, wie in Fig. 1 angedeutet, mehrere Halbleiterchips welche mit einer ersten Hauptelektrode (Anode, Emitter) nebeneinander auf einer Grundplatte angeordnet und elektrisch parallelgeschaltet sind. Zweite Hauptelektroden (Kathode, Kollektor) der Halbleiterchips werden von Kontaktstempeln kontaktiert. Die Kontaktstempel sind mit einem ersten Hauptanschluss 3 und die Grundplatte ist mit einem zweiten Hauptanschluss 4 verbunden. Die Hauptanschlüsse können scheibenförmig ausgebildet sein und mittels Flanschen zusammengehalten werden. Der Kontaktstempel umfasst beispielsweise Federelemente, welche auf die einzelnen Chips drücken. Weitere Anschlüsse (Steuer-/Gateanschlüsse) der Halbleiterchips sind zum Kontaktieren seitlich oder auf einer der Seiten der Hauptanschlüsse 3 oder 4 aus dem Submodul geführt.

Die beiden Submodule sind zwischen den beiden Hauptoberflächen des Moduls, insbesondere zwischen der Deckelplatte 11 und einer nicht dargestellten, von unten an das Modul geführten Grundplatte, eingepresst. Die Grundplatte, beispielsweise als eine von einer Kühlflüssigkeit durchströmte Kühlplatte ausgebildet, ist elektrisch und thermisch gut leitend.

Das Modul weist seitlich aus dem Modulgehäuse geführte Anschlüsse auf, je nach Art der Leistungshalbleiter sind dies Steueranschlüsse G₂₁ und G₂₂ sowie Anschlüsse E₂₁ und C₂₁/E₂₂ welche mit entsprechenden Hauptanschlüssen der Submodule verbunden sind.

In der ersten Ausführungsform des erfindungsgemässen Leistungshalbleiter-Moduls nach Fig. 2 liegt das erste Submodul 21 mit dem ersten Hauptanschluss 3 direkt an der Deckelplatte 11 des Moduls an und ist mit ihr elektrisch leitend verbunden. Mit dem zweiten Hauptanschluss 4 liegt das erste Submodul 21 auf einer Isolierträgerplatte 6 auf, welche im wesentlichen aus einer Schicht 61 aus einem elektrisch isolierenden und thermisch gut leitenden Material besteht. Die Isolierträgerplatte umfasst vorteilhafterweise ein Keramiksubstrat, mit einer beidseitig von Kupferschichten umgebenen Keramikschicht umfasst. Die Kupferschichten sorgen für gute thermische Kontakte und tragen zur Stabilität der Platte bei.

Das zweite Submodul 22 liegt mit dem ersten Hauptanschluss 3 ebenfalls an der Deckelplatte 11 des Moduls an, ist von der jedoch durch eine Schicht 62 aus einem elektrisch isolierenden und thermisch gut leitenden Material elektrisch isoliert. Mit dem zweiten Hauptanschluss 4 ist das zweite Submoduls 22 derart in einer der Öffnungen 51 im Bodenbereich des Gehäuses 5 angeordnet, dass der zweite Hauptanschluss 4 beim Aufbringen des Moduls auf die Grund-, bzw. Kühlplatte den zweiten Hauptanschluss des Moduls C₂₂, bzw. zusammen mit der Isolierträgerplatte 6 die der Deckelplatte 11 gegenüberliegende Hauptoberfläche des Moduls bildet.

Die Isolierträgerplatte 6 und das zweite Submodul 22 sind in den Öffnungen bewegbar angeordnet. Wird das Modul auf eine Grund- bzw. Kühlplatte gebracht und entsprechend mit einer Anpresskraft beaufschlagt, werden Isolierträgerplatte 6 und das zweite Submodul 22 ins Innere des Modulgehäuses und gegen die Deckelplatte gedrückt. Der Bewegungsbereich wird durch das Isoliergehäuse, insbesondere die Wandbereiche, begrenzt. Damit Isolierträgerplatte 6 und Submodul 22 nicht aus dem Modulgehäuse fallen, wenn das Modul nicht auf der Grund- bzw. Kühlplatte angeordnet ist, sind im Bereich der Öffnungen Sicherungsmittel vorgesehen. Beispielsweise können dies an dem Gehäuse angebrachte Anschläge sein, welche die Bewegungsfreiheit der Isolierträgerplatte und des Submoduls entsprechend begrenzen.

Die beiden Submodule der in Fig. 2 dargestellen ersten Ausführungsform des erfindungsgemässen Leistungshalbleiter-Moduls sind elektrisch zu einer Serienschaltung geschaltet. Die Submodule sind beispielsweise jeweils mit einem oder mehreren IGBT und einer parallelen Freilaufdiode bestückt, so dass sich für das Modul das in Fig. 4 dargestellten Schaltungsschema ergibt.

Die beiden Hauptelektroden der Submodule, welche jeweils durch eine Isolierschicht von der angrenzenden Hauptoberfläche des Moduls getrennt sind, die zweite Hauptelektrode 4 des ersten Submoduls 21 sowie die erste Hauptelektrode 3 des zweiten Submoduls 22 also, sind elektrisch miteinander verbunden.

Auf der Isolierträgerplatte 6, zwischen der Isolierschicht 71 und dem zweiten Hauptanschluss 4 des ersten Submoduls 21 ist eine erste elektrisch leitende Verbindungsschicht 71 angeordnet. Dabei handelt es sich beispielsweise um die oben erwähnte Kupferschicht des Keramiksubstrats, oder eine auf dieser Kupferschicht angebrachte weitere Metallschicht. Der zweite Hauptanschluss des Submoduls 21 ist entweder mit der Verbindungsschicht 71 schlüssig, beispielsweise durch Auflöten oder durch eine LTB (Low Temperature Bond)-Verbindung, oder über eine Schicht Wärmeleitpaste und entsprechenden Anpressdruck verbunden.

Auf der gegenüberliegenden Seite, im Bereich des ersten Hauptanschlusses 3 des zweiten Submoduls 22 ist zwischen der Isolierschicht 62 und dem Hauptanschluss 3 des Submoduls eine zweite elektrisch leitende Verbindungsschicht 72 angeordnet.

Die beiden Verbindungsschichten 71 und 72 sind über ein Verbindungselement 8 miteinander elektrisch leitend verbunden. Das Verbindungselement 8 ist beispielsweise analog den beiden Submodulen 21 und 22 aufgebaut und umfasst eine Grundplatte sowie einen oder mehrere Kontaktstempel mit Federelementen. Auf diese Weise ist das Verbindungselement 8 wie die Submodule zwischen den entsprechenden Kontaktflächen komprimierbar. Das in der Regel keine elektronische Elemente enthaltende Verbindungselement 8 kann auch durch ein herkömmliches Submodul mit Halbleiterchips oder anderen elektronischen Elementen ersetzt werden. Das Verbindungselement 8 ist analog dem ersten Submodul auf der Isolierträgerplatte angeordnet bzw. befestigt.

Im Randbereich der Isolierträgerplatte 6 sind Vorsprünge 63 aus elektrisch isolierendem Material vorgesehen. Diese wirken einerseits mit den Anschlägen an den Gehäuseteilen 50 zusammen, andererseits verhindern sie Kriechströme oder Überschläge entlang den angrenzenden Gehäuseteilen. Zudem sorgen sie zusammen mit zwischen dem erstem Submodul 8 und dem Verbindungselement 8 angeordneten Positionierungselementen 64 dafür, dass Submodul 21 und Verbindungselement 8 bezüglich der Isolierträgerplatte 6 sowie dem restlichen Modul richtig positioniert sind.

Emitterseitig, also im Bereich der ersten Hauptanschlüsse 3, sind an den Submodulen 21 und 22 Steueranschlüsse angebracht. Diese sind im Innern der Submodule mit entsprechenden Steuerelektroden der Halbleiterchips verbunden. Diese Steueranschlüsse G₂₁ und G₂₂ werden mit Anschlussleitungen aus dem Gehäuse des Moduls geführt, wo sie zusammen mit dem Emitteranschluss E₂₁ des ersten Submoduls bzw. dem kombinierten Anschluss C₂₁/ E₂₂ auf den Kollektoranschluss des ersten Submoduls und den Emitteranschluss des zweiten Submoduls, welche ebenfalls mit Anschlussleitungen aus dem Gehäuse geführt sind, kontaktiert werden können.

Der Strom fliesst im eingeschalteten Zustand vom zweiten Hauptanschluss des Moduls, dem Kollektoranschluss C₂₂ des zweiten Submoduls 22 durch das zweite Submodul über den Emitteranschluss E₂₂ des zweiten Submoduls, die zweite Verbindungsschicht 72, das Verbindungselement 8, die erste Verbindungsschicht 71 und den Kollektoranschluss C₂₁ des ersten Submoduls 21 durch das erste Submodul zum ersten Hauptanschluss des Moduls, der Deckelplatte 11, bzw. dem Emitteranschluss C21 des ersten Submoduls.

Im sperrenden Zustand fällt jeweils die halbe Sperrspannung über je einem der beiden Submodule an.

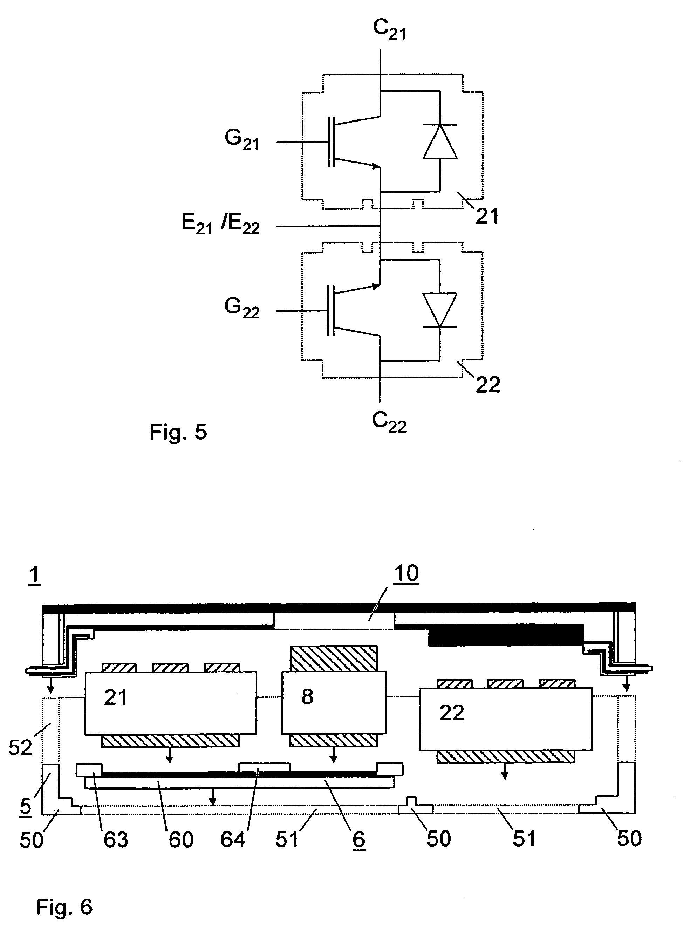

In der zweiten Ausführungsform des erfindungsgemässen Leistungshalbleiter-Moduls nach Fig. 3 sind die beiden Submodule elektrisch zu einer Antiserienschaltung geschaltet. Das heisst, das erste Submodul 21 ist über den zweiten Hauptanschluss 4 mit der Deckelplatte bzw. dem ersten Hauptanschluss des Moduls verbunden und der erste Hauptanschluss 3 des ersten Submoduls 3 ist mit dem ersten Hauptanschluss 3 des zweiten Submoduls 22 verbunden. Wiederum mit IGBT und paralleler Freilaufdiode bestückt, ergibt sich für das Modul das in Fig. 5 dargestellte Schaltungsschema.

Während das zweite Submodul 22 unverändert gegenüber der ersten Ausführungsform angeordnet und elektrisch angeschlossen ist, ist das erste Submodul 21 in der zweiten Ausführugnsform zwar gleich angeordnet, jedoch ist es elektrisch umgekehrt gepolt angeschlossen.

Das erste Submodul 21 liegt zwar auch mit dem ersten Hauptanschluss 3 an der Deckelplatte 11 des Moduls an, ist jedoch nicht elektrisch leitend mit ihr verbunden. Zwischen dem Hauptanschluss des Submoduls und der Deckelplatte ist eine Isolierschicht 62 angeordnet. Es handelt sich dabei um die verlängerte Isolierschicht 62 welche zwischen dem zweiten Submodul 22 und der Deckelplatte 11 angeordnet ist. Die beiden ersten Hauptanschlüsse 3 der beiden Submodule sind über die Verbindungsschicht 72 elektrisch leitend miteinander verbunden. Die Verbindungsschicht ist dabei zwischen den Hauptanschlüssen und der Isolierschicht 62 angeordnet.

Mit dem zweiten Hauptanschluss 4 liegt das erste Submodul 21 wiederum auf der isolierträgerplatte 6. Der zweite Hauptanschluss 4 des ersten Submoduls ist über die auf der Isolierträgerplatte 6 angeordnete Verbindungsschicht 71 und das Verbindungselement 8 elektrisch mit der Deckelplatte 11 verbunden. In der dargestellten, vorteilhaften Ausführungform ist das Verbindungselement 8 durch eine zentrale Öffnung in der Isolier- und Verbindungsschicht 62 und 72 zur Deckelplatte 11 geführt.

Da beide Submodule 21 und 22 gleiche Bauhöhe aufweisen, weist die Verbindungsschicht 72 im Bereich des ersten Hauptanschlusses 3 des zweiten Submoduls 22 eine um die Dicke der Isolierträgerplatte 6, inklusive allfällig darauf angeordneter Verbindungsschicht 71, grössere Dicke auf als im Bereich des ersten Hauptanschlusses des ersten Submoduls 21.

Der Kollektor-Emitter-Strom fliesst somit jeweils von den beiden Hauptanschlüssen des Moduls C₂₁ und C₂₂ entweder durch das Verbindungselement 8, über die Verbindungsschicht 71 und den zweiten Hauptanschluss 4 des ersten Submoduls 21 und durch das erste Submodul 21 zum ersten Hauptanschluss 3der Emitter-Anschluss E₂₁ des, oder durch das zweite Submodul 22 zum entsprechenden Emitter-Anschluss E₂₂. Die durch die Verbindungsschicht 72 miteinander elektrisch leitend verbundenen Emitter-Anschlüsse E₂₁ und E₂₂ sind zum externen Kontaktieren zusammen mit den entsprechenden Steueranschlüssen G₂₁ und G₂₂ über Anschlussleitungen aus dem Modulgehäuse geführt. Anstelle von beiden, kann auch nur einer der Emitteranschlüsse aus dem Gehäuse geführt sein.

In den Darstellungen gemäss Fig. 2 und 3 sind die beiden aus dem Gehäuse geführten Anschlüsse der beiden Submodule jeweils auf gegenüberliegenden Seiten des Moduls angeordnet. In einer vorteilhaften Ausführungsform des erfindungsgemässen Leistungshalbleiter-Moduls sind alle Anschlüsse auf einer Seite des Moduls angeordnet, wodurch die externe Kontaktierung des Moduls über diese Anschlüsse vereinfacht wird. Dazu sind die Anschlussleitungen im Innern des Modulgehäuses entsprechend auf eine Seite geführt.

In einer ganz besonders vorteilhaften Ausführungsform des erfindungsgemässen Leistungshalbleiter-Moduls sind die Anschlussleitungen zusammen mit der zweiten Verbindungsschicht 72 und der Deckelplatte 11 mit einem elektrisch isolierenden Material zu einer Deckeleinheit 10 vergossen. Das elektrisch isolierende Material ist vorteilhafterweise thermisch gut leitend, temperaturbeständig bis zu 160°C, druckbeständig bis zu 30 bar, kriechbeständig, lunkernfrei vergiessbar und weist einen an Kupfer angepassten Ausdehnungskoeffizienten aus. Ein Material welches diese Eigenschaften vereint ist beispielsweise Epoxy. Zur Herstellung der Deckeleinheit wird das Epoxy entweder in einer entsprechenden Form um die elektrisch leitenden Teile vergossen, oder durch Sprayen aufgebracht.

Wie die einzelnen Elemente des erfindungsgemässen Leistungshalbleiter-Moduls beim Montieren zusammengebaut werden, ist anhand der Darstellung in Fig. 6 ersichtlich.

In das mit den Öffnungen 51 versehene Gehäuse wird in einem ersten Montageschritt die Isolierträgerplatte 6 eingelegt. Durch Anschläge an den Gehäuseteilen 50 im Bereich der Öffnungen 51 wird die Isolierträgerplatte 6 gehalten. An der Isolierplatte 6 sind im Randbereich die Isolierabschlüsse 63 angebracht welche wie aus der Figur ersichtlich, mit den entsprechenden Anschlägen an den Gehäuseteilen 50 zusammenwirken.

In einem nächsten Montageschritt werden die Submodule 21 und 22 sowie das Verbindungselement 8 in das Gehäuse geführt. Das erste Submodul 21 und das Verbindungselement 8 werden auf der Isolierträgerplatte 8 befestigt, während das zweite Submodul 22 in die dafür vorgesehene Öffnung 51 eingelegt wird. Auch das zweite Submodul 22 wird durch entsprechende Anschläge an den Gehäuseteilen 50 am Herausfallen gehindert. Zur genauen Positionierung des ersten Submoduls 21 und des Verbindungselements 8 auf der Isolierträgerplatte 8 sind Positionierelemente 64 auf der Isolierträgerplatte 6 angeordnet. Die Isolierabschlüsse 63 dienen ebenfalls der Positionierung.

Alternativ werden erstes Submodul 21 und Verbindungselement 8 auf der Isolierträgerplatte 6 angebracht und allenfalls daran befestigt, bevor die Isolierträgerplatte in das Gehäuse gelegt wird.

In einem weiteren Montageschritt wird die Deckeleinheit 10 auf das Gehäuse aufgesetzt. Die in der Deckeleinheit integrierten Verbindungsschichten und Anschlussleitungen werden dank der genauen Positionierung der Submodule mit den entsprechenden Kontaktanschlüssen der Submodule zusammengeführt. Die Anpresskraft auf den Gehäusedeckel sorgt für die notwendige Kontaktkraft für die druckkontaktierten Kontaktanschlüsse der Submodule. Zum Verbessern des elektrischen und thermischen Übergangs, kann zwischen den druckkontatktierten Kontaktflächen entsprechende Wärmeleitpaste aufgetragen werden.

Die erwähnte Serien- bzw. Antiserienschaltung von Halbleiterchips kann auch durch entsprechendes Umkehren (Wenden) der Submodule, bzw. der im Submodul angeordneten Halbleiterchips erreicht werden. Beispielsweise lässt sich durch ein gewendetes erstes Submodul (Flip-Submodul) in der oben erwähnten ersten Ausführungsform die Antiserienschaltung ensprechend der Schaltung nach Fig. 5 realisieren. Somit ist es möglich, durch einfaches Umkehren des entsprechenden Submoduls mit einem Gehäuse sowohl Schalter mit erhöhter Sperrspannung zu realisiern, als auch die oben erwähnten Wechselstromschalter.

Im Sinne der Erfindung umfasst der allgemeine Begriff der Serienschaltung auch das Hintereinanderschalten zweier Komponenten mit entgegengesetzter Polarität (Anti-Serienschaltung).

### Bezugszeichenliste

- 1: Leistungshalbleiter-Modul
- 10: Deckeleinheit
- 11: Deckelplatte
- 2, 21, 22: Submodul
- 3, 4: Hauptanschlüsse
- 5, 50: Isoliergehäuse
- 51, 52: Öffnungen
- 6: Isolierträgerplatte
- 61, 62: Isolierschichten
- 63: Isolierabschlüsse
- 64: Positionierungselement
- 71, 72: Verbindungsschichten
- 8: Verbindungselement
- C, C₂₁, C₂₂: Kollektor-Anschluss
- E, E₂₁, E₂₂: Emitter-Anschluss
- G, G₂₁, G₂₂: Gate-Anschluss

## Patentansprüche

1. Leistungshalbleiter-Modul mit
- zwei elektrischen Hauptanschlüssen, welche auf einander gegenüberliegenden, im wesentlichen parallelen Hauptoberflächen des Moduls angeordnet sind, wobei ein erster der beiden Hauptanschlüsse des Leistungshalbleiter-Moduls als eine elektrisch leitende Deckelplatte (11) ausgebildet ist,
- einem mit der Deckelplatte (11) verbundenen, elektrisch isolierenden Gehäuse (5), welches zwischen den beiden Hauptanschlüssen angeordnet ist, in welchem Gehäuse (5) im Bereich der der Deckelplatte (11) gegenüberliegenden Hauptoberfläche des Moduls mindestens eine Öffnung (51) eingelassen ist, und
- mindestens zwei Submodulen (2, 21, 22), wobei die Submodule
- je zwei elektrische Hauptanschlüsse (3, 4) aufweisen, welche auf je einer von zwei einander gegenüberliegenden, im wesentlichen parallelen Hauptoberflächen der Submodule angeordnet sind,
- je mindestens einen Halbleiterchip umfassen, welcher zwei Hauptelektroden aufweist, welche mit den Hauptanschlüssen (3, 4) des Submoduls elektrisch leitend verbunden sind, und
- nebeneinander angeordnet sind,
und wobei
- mindestens zwei Submodule (21, 22) elektrisch in Serie oder in Antiserie geschaltet sind und
- die Submodule (21, 22) derart bewegbar in den Öffnungen (51) des Gehäuses angeordnet sind, dass die Submodule (21, 22) mit einer Anpresskraft beaufschlagbar mit jeweils einer der beiden Hauptoberflächen an die Deckelplatte (11) anpressbar sind.

2. Leistungshalbleiter-Modul nach Anspruch 1, **dadurch gekennzeichnet, dass**
- die in Serie geschalteten Submodule (21, 22) über je einen Hauptanschluss (3, 4) und eine Verbindung (71, 72, 8) miteinander elektrisch leitend verbunden sind, und dass
- zwischen den miteinander verbundenen Hauptanschlüssen (3, 4) der Submodule (21, 22) und der jeweiligen Hauptoberfläche des Moduls eine elektrisch isolierende Schicht (61, 62) angeordnet ist.

3. Leistungshalbleiter-Modul nach Anspruch 2, **dadurch gekennzeichnet, dass**
- ein erster Hauptanschluss (3) mindestens eines ersten Submoduls (21) mit der Deckelplatte (11) elektrisch leitend verbunden ist, dass
- zwischen einem zweiten Hauptanschluss (4) des mindestens einen ersten Submoduls (21) und der der Deckelplatte (11) gegenüberliegenden Hauptoberfläche des Moduls eine erste elektrisch isolierende Schicht (61) angeordnet ist, dass
- zwischen einem ersten Hauptanschluss (3) mindestens eines zweiten Submoduls (22) und der Deckelplatte (11) eine zweite elektrisch isolierende Schicht (62) angeordnet ist, dass
- ein zweiter Hauptanschluss (4) des mindestens einen zweiten Submoduls (22) mit dem zweiten Hauptanschluss des Moduls elektrisch leitend verbunden ist, und dass
- der zweite Hauptanschluss (4) des mindestens einen ersten Submoduls (21) mit dem ersten Hauptanschluss (3) des mindestens einen zweiten Submoduls (22) über eine Verbindung (71, 72, 8) elektrisch leitend verbunden ist.

4. Leistungshalbleiter-Modul nach Anspruch 3, **dadurch gekennzeichnet, dass**
- die Verbindung
- eine erste elektrisch leitende Verbindungsschicht (71), welche zwischen dem zweiten Hauptanschluss (4) des mindestens einen ersten Submoduls (21) und der ersten Isolierschicht (61) angeordnet ist,
- eine zweite elektrisch leitende Verbindungsschicht (72), welche zwischen dem ersten Hauptanschluss (3) des mindestens einen zweiten Submoduls (22) und der zweiten Isolierschicht (62) angeordnet ist, und
- ein Verbindungselement (8), welches die erste Verbindungsschicht (71) mit der zweiten Verbindungsschicht (72) elektrisch leitend verbindet,
umfasst.

5. Leistungshalbleiter-Modul nach Anspruch 2, **dadurch gekennzeichnet, dass**
- zwischen einem zweiten Hauptanschluss (4) mindestens eines ersten Submoduls (21) und der der Deckelplatte (11) gegenüberliegenden Hauptoberfläche des Moduls eine erste elektrisch isolierende Schicht (61) angeordnet ist, dass
- der zweite Hauptanschluss (4) des mindestens einen ersten Submoduls (21) über eine erste Verbindung (71, 8) mit der Deckelplatte (11) elektrisch leitend verbunden ist, dass
- zwischen einem ersten Hauptanschluss (4,3) des mindestens einen ersten Submoduls (21) und der Deckelplatte (11) sowie zwischen einem ersten Hauptanschluss (3) mindestens eines zweiten Submoduls (22) und der Deckelplatte (11) eine zweite elektrisch isolierende Schicht (62) angeordnet ist, dass
- ein zweiter Hauptanschluss (4) des mindestens einen zweiten Submoduls (22) mit dem zweiten Hauptanschluss des Moduls elektrisch leitend verbunden ist, und dass
- der erste Hauptanschluss (3) des mindestens einen ersten Submoduls (21) mit dem ersten Hauptanschluss (3) des mindestens einen zweiten Submoduls (22) über zweite Verbindung (72) elektrisch leitend verbunden ist.

6. Leistungshalbleiter-Modul nach Anspruch 5, **dadurch gekennzeichnet, dass**
- die erste Verbindung
- eine erste elektrisch leitende Verbindungsschicht (71), welche zwischen dem zweiten Hauptanschluss (4) des mindestens einen ersten Submoduls (21) und der ersten Isolierschicht (61) angeordnet ist,
- ein Verbindungselement (8), welches die erste Verbindungsschicht (71) mit der Deckelplatte (11) elektrisch leitend verbindet,
umfasst, und
- die zweite Verbindung
- eine zweite elektrisch leitende Verbindungsschicht (72), welche zwischen dem ersten Hauptanschluss (4) des mindestens einen ersten Submoduls (21) und der zweiten Isolierschicht (62) sowie zwischen dem ersten Hauptanschluss (3) des mindestens einen zweiten Submoduls (22) und der zweiten Isolierschicht (62) angeordnet ist,
umfasst.

7. Leistungshalbleiter-Modul nach Anspruch 6, **dadurch gekennzeichnet, dass**
- in die zweite Verbindungsschicht (72) und in die zweite Isolierschicht (62) eine Öffnung eingelassen ist, und dass
- das Verbindungselement (8) zum Verbinden der ersten Verbindungsschicht (71) mit der Deckelplatte (11) durch die Öffnung geführt ist.

8. Leistungshalbleiter-Modul nach einem der Ansprüche 6 oder 7, **dadurch gekennzeichnet, dass**
- die zweite Verbindungsschicht (72) im Bereich zwischen dem ersten Hauptanschluss (3) des mindestens einen zweiten Submoduls (22) und der zweiten Isolierschicht (62) eine grössere Dicke, insbesondere eine um die Summe der Dicke der ersten Isolierschicht (61) und der Dicke der ersten Verbindungsschicht (71) grössere Dicke, aufweist als im Bereich zwischen dem ersten Hauptanschluss (4) des mindestens einen ersten Submoduls (21) und der zweiten Isolierschicht (62).

9. Leistungshalbleiter-Modul nach einem der Ansprüche 3 bis 8, **dadurch gekennzeichnet, dass**
- die erste Isolierschicht (61) Teil einer Isolierträgerplatte (6) ist und dass
- die Isolierträgerplatte (6) in der Öffnung (51) des Gehäuses (5) angeordnet ist.

10. Leistungshalbleiter-Modul nach Anspruch 9, **dadurch gekennzeichnet, dass**
- die Isolierträgerplatte (6) senkrecht zur Deckelplatte (11) bewegbar ist.

11. Leistungshalbleiter-Modul nach Anspruch 10, **dadurch gekennzeichnet, dass**
- im Bereich der Öffnung (51) Mittel zum Begrenzen des Bewegungsbereichs der Isolierträgerplatte (6), insbesondere am Gehäuse (5) und/ oder an der ersten Isolierschicht (61) angeordnete Anschläge, angeordnet sind.

12. Leistungshalbleiter-Modul nach einem der Ansprüche 1 bis 11, **dadurch gekennzeichnet, dass**
- die Hauptanschlüsse (3, 4) und/ oder weitere Anschlüsse (G₂₁, G₂₂) der Submodule zum Kontaktieren mit Anschlussleitungen aus dem Modulgehäuse (5) geführt sind.

13. Leistungshalbleiter-Modul nach Anspruch 12, **dadurch gekennzeichnet, dass**
- die Deckelplatte (11), die Anschlussleitungen, zwischen Submodul und Deckelplatte angeordnete Isolierschichten (62) und zwischen Submodul und Deckelplatte angeordnete Verbindungsschichten (72) als eine vorfabrizierbare Deckeleinheit (10) ausgebildet sind.

14. Leistungshalbleiter-Modul nach Anspruch 13, **dadurch gekennzeichnet, dass**
- die Deckelplatte (11), die Anschlussleitungen und die zwischen Submodul und Deckelplatte angeordneten Verbindungsschichten (72) mit einem elektrisch isolierenden Material vergossen sind.

15. Anordnung aus einem Leistungshalbleiter-Modul nach einem der Ansprüche 1 bis 14 und einer Grundplatte, **dadurch gekennzeichnet, dass**
- das Modul im Bereich der der Deckelplatte (11) gegenüberliegenden Hauptoberfläche des Moduls auf der Grundplatte angeordnet ist und dass
- die Submodule mit einer Anpresskraft beaufschlagt zwischen der Deckelplatte (11) und der Grundplatte eingepresst sind.

## Claims

1. Power semiconductor module having
- two main electrical connections which are arranged on mutually opposite, essentially parallel, main surfaces of the module, with a first of the two main connections of the power semi conductor module being in the form of an electrically conductive covering plate (11),
- an electrically insulating housing (5) which is connected to the covering plate (11) and is arranged between the two main connections, in which housing (5) at least one opening (51) is incorporated in the region of the main surface of the module which is opposite the covering plate (11), and
- at least two submodules (2, 21, 22), with the submodules
- having in each case two main electrical connections (3, 4) which are arranged on in each case one of two mutually opposite, essentially parallel, main surfaces of the submodules,
- comprising in each case at least one semiconductor chip, which has two main electrodes which are electrically conductively connected to the main connections (3, 4) of the submodule, and
- being arranged alongside one another,
and
- at least two submodules (21, 22) being electrically connected in series or back-to-back in series, and
- the submodules (21, 22) being arranged to be movable in the openings (51) of the housing in such a way that the submodules (21, 22) can be pressed with in each case one of the two main surfaces against the covering plate (11) by a contact force that can be applied to them.

2. Power semiconductor module according to Claim 1, **characterized in that**
- the series-connected submodules (21, 22) are electrically conductively connected to one another via in each case one main connection (3, 4) and one connection (71, 72, 8), and **in that**
- an electrically insulating layer (61, 62) is arranged between the main connections (3, 4), which are connected to one another, of the submodules (21, 22) and of the respective main surface of the module.

3. Power semiconductor module according to Claim 2, **characterized in that**
- a first main connection (3) of at least one first submodule (21) is electrically conductively connected to the covering plate (11), **in that**
- a first electrically insulating layer (61) is arranged between a second main connection (4) of the at least one first submodule (21) and that main surface of the module which is opposite the covering plate (11), **in that**
- a second electrically insulating layer (62) is arranged between a first main connection (3) of at least one second submodule (22) and the covering plate (11), **in that**
- a second main connection (4) of the at least one second submodule (22) is electrically conductively connected to the second main connection of the module, and **in that**
- the second main connection (4) of the at least one first submodule (21) is electrically conductively connected to the first main connection (3) of the at least one second submodule (22), via a connection (71, 72, 8).

4. Power semiconductor module according to Claim 3, **characterized in that**
- the connection comprises
- a first electrically conductive connection layer (71), which is arranged between the second main connection (4) of the at least one first submodule (21) and the first insulating layer (61),
- a second electrically conductive connection layer (72), which is arranged between the first main connection (3) of the at least one second submodule (22) and the second insulating layer (62), and
- a connection element (8), which electrically conductively connects the first connection layer (71) to the second connection layer (72).

5. Power semiconductor module according to Claim 2, **characterized in that**
- a first electrically insulating layer (61) is arranged between a second main connection (4) of at least one first submodule (21) and that main surface of the module which is opposite the covering plate (11), **in that**
- the second main connection (4) of the at least one first submodule (21) is electrically conductively connected to the covering plate (11) via a first connection (71, 8), **in that**
- a second electrically insulating layer (62) is arranged between a first main connection (3) of the at least one first submodule (21) and the covering plate (11), as well as between a first main connection (3) of at least one second submodule (22) and the covering plate (11), **in that**
- a second main connection (4) of the at least one second submodule (22) is electrically conductively connected to the second main connection of the module, and **in that**
- the first main connection (3) of the at least one first submodule (21) is electrically conductively connected to the first main connection (3) of the at least one second submodule (22) via a second connection (72).

6. Power semiconductor module according to Claim 5, **characterized in that**
- the first connection comprises
- a first electrically conductive connection layer (71), which is arranged between the second main connection (4) of the at least one first submodule (21) and the first insulating layer (61),
- a connection element (8), which electrically conductively connects the first connection layer (71) to the covering plate (11)
and
- the second connection comprises
- a second electrically conductive connection layer (72), which is arranged between the first main connection (3) of the at least one first submodule (21) and the second insulation layer (62), as well as between the first main connection (3) of the at least one second submodule (22) and the second insulating layer (62).

7. Power semiconductor module according to Claim 6, **characterized in that**
- an opening is incorporated in the second connection layer (72) and in the second insulating layer (62), and **in that**
- the connection element (8) for connecting the first connection layer (71) to the covering plate (11) is passed through the opening.

8. Power semiconductor module according to one of Claims 6 or 7, **characterized in that**
- the second connection layer (72) has a greater thickness, in particular a thickness which is greater by the sum of the thickness of the first insulating layer (61) and the thickness of the first connection layer (71), in the region between the first main connection (3) of the at least one second submodule (22) and the second insulating layer (62) than in the region between the first main connection (3) of the at least one first submodule (21) and the second insulating layer (62).

9. Power semiconductor module according to one of Claims 3 to 8, **characterized in that**
- the first insulating layer (61) is part of an insulating mounting panel (6), and **in that**
- the insulating mounting panel (6) is arranged in the opening (51) of the housing (5).

10. Power semiconductor module according to Claim 9, **characterized in that**
- the insulating mounting panel (6) can move at right angles to the covering plate (11).

11. Power semiconductor module according to Claim 10, **characterized in that**
- means for limiting the movement range of the insulating mounting panel (6) are arranged in the region of the opening (51), in particular stops which are arranged on the housing (5) and/or on the first insulating layer (61).

12. Power semiconductor module according to one of Claims 1 to 11, **characterized in that**
- the main connections (3, 4) and/or further connections (G₂₁, G₂₂) of the submodules are passed out of the module housing (5) in order to make contact with connecting leads.

13. Power semiconductor module according to Claim 12, **characterized in that**
- the covering plate (11), the connecting leads, insulating layers (62) which are arranged between the submodule and the covering plate, and connection layers (72) which are arranged between the submodule and the covering plate are in the form of a cover unit (10) which can be prefabricated.

14. Power semiconductor module according to Claim 13, **characterized in that**
- the covering plate (11), the connecting leads and the connection layers (72) which are arranged between the submodule and the covering plate are encapsulated with an electrically insulating material.

15. Arrangement comprising a power semiconductor module according to one of Claims 1 to 14 and a base plate, **characterized in that**
- the module is arranged on the base plate in the region of the main suface of the module which is opposite the covering plate (11), and **in that**
- the submodules are pressed in between the covering plate (11) and the base plate by a contact force that is applied to them.

## Revendications

1. Module semi-conducteur de puissance présentant :
deux bornes principales de raccordement électrique disposées sur des surfaces principales opposées, essentiellement parallèles, du module, une première des deux bornes principales de raccordement du module semi-conducteur de puissance étant configurée comme plaque électriquement conductrice de couvercle (11),
un boîtier électriquement isolant (5) relié à la plaque de couvercle (11) et disposé entre les deux bornes principales de raccordement, au moins une ouverture (51) étant ménagée dans ce boîtier (5) au niveau de la surface principale du module opposée à la plaque de couvercle (11) et
au moins deux sous-modules (2, 21, 22) qui
présentent chacun deux bornes principales de raccordement électrique (3, 4) disposées chacune sur une des deux surfaces principales essentiellement parallèles et mutuellement opposées des sous-modules,
comportent chacun au moins une puce semiconductrice qui présente deux électrodes principales raccordées de manière électriquement conductrice aux bornes principales de raccordement (3, 4) du sous-module et
sont disposés l'un à côté de l'autre,
au moins deux sous-modules (21, 22) étant raccordés électriquement en série ou en anti-série et
les sous-modules (21, 22) étant disposés dans les ouvertures (51) du boîtier de manière à pouvoir se déplacer de telle sorte qu'une force de poussée puisse être appliquée sur les sous-modules (21, 22) et que les sous-modules puissent chacun être repoussés par une des deux surfaces principales contre la plaque de couvercle (11).

2. Module semi-conducteur de puissance selon la revendication 1, **caractérisé en ce que** les sous-modules (21, 22) raccordés en série sont raccordés l'un à l'autre de manière électriquement conductrice par une borne principale de raccordement (3, 4) et une liaison (71, 72, 8) et **en ce qu'**une couche électriquement isolante (61, 62) est disposée entre les bornes principales de raccordement (3, 4), reliées l'une à l'autre, des sous-modules (21, 22) et la surface principale correspondante du module.

3. Module semi-conducteur de puissance selon la revendication 2, **caractérisé en ce que**
une première borne principale de raccordement (3) d'au moins un premier sous-module (21) est reliée de manière électriquement conductrice à la plaque du couvercle (11),
**en ce qu'**une première couche électriquement isolante (61) est disposée entre une deuxième borne principale de raccordement (4) du ou des premiers sous-modules (21) et la surface principale du module opposée à la plaque de couvercle (11),
**en ce qu'**une deuxième couche électriquement isolante (62) est disposée entre une première borne principale de raccordement (3) d'au moins un deuxième sous-module (22) et la plaque de couvercle (11),
**en ce qu'**une deuxième borne principale de raccordement (4) du ou des deuxièmes sous-modules (22) est raccordée de manière électriquement conductrice à la deuxième borne principale de raccordement du module et
**en ce que** la deuxième borne principale de raccordement (4) du ou des premiers sous-modules (21) est reliée de manière électriquement conductrice à la première borne principale de raccordement (3) du ou des deuxièmes sous-modules (22) par une liaison (71, 72, 8).

4. Module semi-conducteur de puissance selon la revendication 3, **caractérisé en ce que** la liaison comporte
une première couche électriquement conductrice de liaison (71) disposée entre la deuxième borne principale de raccordement (4) du ou des premiers sous-modules (21) et la première couche isolante (61),
une deuxième couche électriquement conductrice de liaison (72) disposée entre la première borne principale de raccordement (3) du ou des deuxièmes sous-modules (22) et la deuxième couche isolante (62) et
un élément de liaison (8) qui relie de manière électriquement conductrice la première couche de liaison (71) à la deuxième couche de liaison (72).

5. Module semi-conducteur de puissance selon la revendication 2, **caractérisé en ce que**
une première couche électriquement isolante (61) est disposée entre une deuxième borne principale de raccordement (4) d'au moins un premier sous-module (21) et la surface principale du module opposée à la plaque de couvercle (11),
**en ce que** la deuxième borne principale de raccordement (4) du ou des premiers sous-modules (21) est reliée de manière électriquement conductrice à la plaque de couvercle (11) par une première liaison (71, 8),
**en ce qu'**une deuxième couche électriquement isolante (62) est disposée entre une première borne principale de raccordement (4) du ou des premiers sous-modules (21) et la plaque de couvercle (11) ainsi qu'entre une première borne principale de raccordement (3) d'au moins un deuxième sous-module (22) et la plaque de couvercle (11),
**en ce qu'**une deuxième borne principale de raccordement (4) du ou des deuxièmes sous-modules (22) est reliée de manière électriquement conductrice à la deuxième borne principale de raccordement du module et
**en ce que** la première borne principale de raccordement (3) du ou des premiers sous-modules (21) est reliée de manière électriquement conductrice à la première borne principale de raccordement (3) du ou des deuxièmes sous-modules (22) par une deuxième liaison (72).

6. Module semi-conducteur de puissance selon la revendication 5, **caractérisé en ce que** la première liaison comprend
une première couche électriquement conductrice de liaison (71) disposée entre la deuxième borne principale de raccordement (4) du ou des premiers sous-modules (21) et la première couche isolante (61) et un élément de liaison (8) qui relie de manière électriquement conductrice la première couche de liaison (71) à la plaque de couvercle (11) et
**en ce que** la deuxième liaison présente une deuxième couche électriquement conductrice de liaison (72) disposée entre la première borne principale de raccordement (4) du ou des premiers sous-modules (21) et la deuxième couche isolante (62) ainsi qu'entre la première borne principale de raccordement (3) du ou des deuxièmes sous-modules (22) et la deuxième couche isolante (62).

7. Module semi-conducteur de puissance selon la revendication 6, **caractérisé en ce que**
une ouverture est ménagée dans la deuxième couche de liaison (72) et dans la deuxième couche isolante (62) et
**en ce que** l'élément de liaison (8) est passé dans l'ouverture pour relier la première couche de liaison (71) à la plaque de couvercle (11).

8. Module semi-conducteur de puissance selon l'une des revendications 6 ou 7, **caractérisé en ce qu'**au niveau situé entre la première borne principale de raccordement (3) du ou des deuxièmes sous-modules (22) et la deuxième couche isolante (62), la deuxième couche de liaison (72) présente une épaisseur plus grande, notamment une épaisseur augmentée de la somme de l'épaisseur de la première couche isolante (61) et de l'épaisseur de la première couche de liaison (71), qu'au niveau situé entre la première borne principale de raccordement (4) du ou des premiers sous-modules (21) et la deuxième couche isolante (62).

9. Module semi-conducteur de puissance selon l'une des revendications 3 à 8, **caractérisé en ce que** la première couche isolante (61) fait partie d'une plaque isolante de support (6) et **en ce que** la plaque isolante de support (6) est disposée dans l'ouverture (51) du boîtier (5).

10. Module semi-conducteur de puissance selon la revendication 9, **caractérisé en ce que** la plaque isolante de support (6) peut être déplacée perpendiculairement à la plaque de couvercle (11).

11. Module semi-conducteur de puissance selon la revendication 10, **caractérisé en ce que** des moyens qui limitent la plage de déplacement de la plaque isolante de support (6) sont disposés au niveau de l'ouverture (51), en particulier sur le boîtier (5) et/ou sur des butées disposées sur la première couche isolante (61).

12. Module semi-conducteur de puissance selon l'une des revendications 1 à 11, **caractérisé en ce que** les bornes principales de raccordement (3, 4) et/ou d'autres bornes de raccordement (G₂₁, G₂₂) du sous-module sont prolongées à l'extérieur du boîtier (5) du module pour assurer le contact avec des conducteurs de raccordement.

13. Module semi-conducteur de puissance selon la revendication 12, **caractérisé en ce que** la plaque de couvercle (11), les conducteurs de raccordement, les couches isolantes (62) disposées entre le sous-module et la plaque de recouvrement et les couches de liaison (72) disposées entre les sous-modules et la plaque de recouvrement sont configurés comme unités de couvercle (10) préfabriquées.

14. Module semi-conducteur de puissance selon la revendication 13, **caractérisé en ce que** la plaque de couvercle (11), les conducteurs de raccordement et les couches de liaison (72) disposées entre les sous-modules et la plaque de couvercle sont englobés dans un matériau électriquement isolant.

15. Ensemble constitué d'un module semi-conducteur de puissance selon l'une des revendications 1 à 14 et d'une plaque de base, **caractérisé en ce que**
le module est disposé sur la plaque de base au niveau de la surface principale du module opposée à la plaque de couvercle (11) et
**en ce qu'**une force de poussée est appliquée sur les sous-modules et les comprime entre la plaque de couvercle (11) et la plaque de base.
